# EUROPÄISCHE PATENTSCHRIFT

(11) **EP 2 812 536 B1**
(45) Veröffentlichungstag und Bekanntmachung des Hinweises auf die Patenterteilung: **20.04.2016**
(21) Anmeldenummer: 13703731.3
(22) Anmeldetag: 05.02.2013
(51) Int. Cl.: F01D 5/02, F01D 5/28, C23C 8/08

(54) **VERFAHREN ZUM HERSTELLEN EINES TURBINENROTORS EINES ABGASTURBOLADERS**
METHOD FOR PRODUCING A TURBINE ROTOR OF A TURBOCHARGER
PROCÉDÉ DE PRODUCTION D'UN ROTOR DE TURBINE D'UN TURBO-COMPRESSEUR

(30) Priorität: 06.02.2012 DE 102012002284
(43) Veröffentlichungstag der Anmeldung: 17.12.2014
(73) Patentinhaber: Audi AG, 85045 Ingolstadt (DE)
(72) Erfinder: HENKER, Oliver, 02906 Quitzdorf am See (DE); STICH, Anton, 85051 Ingolstadt (DE)
(86) Internationale Anmeldenummer: PCT/EP2013/000339
(87) Internationale Veröffentlichungsnummer: WO 2013/117316

(56) Entgegenhaltungen:
- EP-A1- 2 204 466
- EP-A2- 1 462 537
- EP-A2- 1 621 774
- JP-A- 2002 332 569
- DONCHEV A ET AL: "The halogen effect for improving the oxidation resistance of TiAl-alloys", MATERIALS AT HIGH TEMPERATURES, BUTTERWORTH HEINEMANN, GUILDFORD, GB, Bd. 22, Nr. 3-4, 1. Januar 2005 (2005-01-01), Seiten 309-314, XP009089959, ISSN: 0960-3409

## Beschreibung

Die Erfindung betrifft ein Verfahren zum Herstellen eines Turbinenrotors eines Abgasturboladers, wobei der Turbinenrotor aus einem Turbinenrad mit einer Nabe und mit von der Nabe ausgehenden Turbinenschaufeln sowie einer Welle besteht. Die Erfindung betrifft weiterhin die Verwendung eines Turbinenrotors.

Das Ansprechverhalten beziehungsweise der Drehmomentaufbau einer mithilfe eines Abgasturboladers aufgeladenen Brennkraftmaschine hängt maßgeblich von dem Massenträgheitsmoment des Laufzeugs des Abgasturboladers, insbesondere von dessen Turbinenrotors, ab. Der Großteil des Massenträgheitsmoments entsteht durch die Masse des Turbinenrads, welche Bestandteil des Turbinenrotors ist. Je geringer sie ist, umso schneller kann der Drehmomentaufbau erfolgen. Entsprechend kann durch Verringerung der Masse des Turbinenrads das Ansprechverhalten der Brennkraftmaschine verbessert werden. Eine Möglichkeit, die Masse des Turbinenrads zu reduzieren ist der Ersatz der üblicherweise verwendeten Nickel-Basislegierung, welche eine Dichte von etwa 8 g/cm³ aufweist, durch ein anderes Material mit einer geringeren Dichte. Das für das Turbinenrad verwendete Material verfügt idealerweise über vergleichbare Hochtemperatureigenschaften, insbesondere bei Temperaturen von mehr als 800°C, wie die Nickel-Basislegierungen. Materialien, welche über die genannten Eigenschaften verfügen, also insbesondere eine geringe Dichte und gute Hochtemperatureigenschaften aufweisen, sind jedoch üblicherweise bei den in dem Abgasturbolader bedingt durch die Durchströmung mit heißem Abgas der Brennkraftmaschine auftretenden Temperaturen von mehr als 800°C nicht oxidationsbeständig. Das bedeutet, dass sie während des Betriebs des Abgasturboladers einem Oxidationsprozess ausgesetzt sind, welcher die Oberfläche des Turbinenrads negativ beeinflusst. Dies gilt insbesondere für die Turbinenschaufeln, welche unmittelbar mit dem heißen Abgas beaufschlagt sind, jedoch grundsätzlich auch für die Nabe, an der die Turbinenschaufeln angeordnet sind.

Aus dem Stand der Technik sind die Druckschriften EP 1 621 774 A2 sowie EP 2 204 466 A1 bekannt. Erstere zeigt ein TiAl-Turbinenrad, welches auf einer Stahlwelle angeordnet ist. Letztere offenbart ein Oberflächenbehandlungsverfahren für TiAl-Legierungen, bei welchem eine Behandlung mit einem fluorhaltigen Gas vorgesehen ist.

Es ist daher Aufgabe der Erfindung, ein Verfahren zum Herstellen eines Turbinenrotors eines Abgasturboladers vorzuschlagen, das zum Einen kostengünstig durchführbar ist und zum Anderen das Herstellen eines Turbinenrotor ermöglicht, welcher auch bei hohen Temperaturen, wie sie in dem Abgasturbolader auftreten, oxidationsbeständig ist. Dabei soll der Turbinenrotor beispielsweise aus einem Material bestehen, welches im Vergleich mit der üblicherweise verwendeten Nickel-Basislegierung eine geringe Dichte aufweist.

Dies wird erfindungsgemäß mit dem Verfahren mit den Merkmalen des Anspruchs 1 erreicht. Dieses umfasst die Schritte: Bereitstellen des Turbinenrads sowie der Welle; Ausbilden einer Schutzschicht durch Aufbringen oder Einbringen eines Halogens auf beziehungsweise in die Oberfläche des Turbinenrads, bevorzugt die gesamte Oberfläche, sowie anschließendes Wärmebehandeln des Turbinenrads; und Verbinden der Welle mit der Nabe des Turbinenrads. Der Turbinenrotor liegt als gebauter Turbinenrotor vor. Das bedeutet, dass er sich aus dem Turbinenrad und der Welle zusammensetzt, welche getrennt voneinander ausgebildet beziehungsweise hergestellt werden. Bei dem Herstellen des Turbinenrotors erfolgt mithin ein Verbinden der Welle mit dem Turbinenrad, so dass diese nachfolgend als Einheit in Form des Turbinenrotors vorliegen. Dazu werden zunächst das Turbinenrad sowie die Welle bereitgestellt. Dieses Bereitstellen kann auch ein Herstellen umfassen, wobei das Turbinenrad insbesondere durch Gießen hergestellt wird. Das Turbinenrad wird aus einer Titan-Aluminiumlegierung hergestellt.

Nach dem Bereitstellen des Turbinenrads wird auf diesem die Schutzschicht ausgebildet. Dies erfolgt durch das Aufbringen beziehungsweise Einbringen des Halogens, wobei die (bevorzugt gesamte) Oberfläche des Turbinenrads mit dem Halogen behandelt wird. Selbstverständlich kann das Halogen auch nur auf einen Bereich der Oberfläche aufgebracht beziehungsweise in diese eingebracht werden. Insbesondere im Bereich der Nabe kann lediglich ein bereichsweises Aufbringen/Einbringen vorgesehen sein. Das Aufbringen/Einbringen des Halogens kann auf beliebige Art und Weise erfolgen. Beispielsweise ist dazu ein lonenimplantationsverfahren, ein Tauchverfahren, ein Sprühverfahren oder ein Aufstreichverfahren vorgesehen. Als lonenimplantationsverfahren kommt zur Ionenimplantation beispielsweise ein Plasma-Immersions-Ionenimplantationsverfahren beziehungsweise ein Beamline-Ionenimplantationsverfahren oder dergleichen zum Einsatz. Als Halogen kann insbesondere Fluor, Chlor, Brom, Jod oder eine Mischung aus diesen Elementen verwendet werden. Das Aufbringen beziehungsweise Einbringen des Halogens soll, wie bereits vorstehend festgehalten, auf beziehungsweise in die Oberfläche des Turbinenrads, nicht jedoch der Welle, erfolgen.

Nach dem Aufbringen beziehungsweise Einbringen wird das Turbinenrad, insbesondere das gesamte Turbinenrad, einer Wärmebehandlung unterzogen. Diese Wärmebehandlung, welche auch als thermische Aktivierung beziehungsweise Voroxidation bezeichnet werden kann, erfolgt bei mindestens 500°C bis 900°C. Während der Wärmebehandlung erfolgt die Ausbildung einer thermisch beständigen Schutzschicht. Diese schützt das Turbinenrad vor einer unzulässigen Oxidation während des Betriebs des Abgasturboladers. Nach dem Ausbilden der Schutzschicht wird die Welle mit der Nabe des Turbinenrads verbunden und so der Turbinenrotor erlangt. Die hier beschriebene Reihenfolge hat den Vorteil, dass die Welle erst nach der Wärmebehandlung des Turbinenrads mit diesem verbunden wird. Die Welle wird also während der Wärmebehandlung des Turbinenrads nicht temperaturbeaufschtagt. Es kann also nicht zu einer unzulässigen Oxidation der Welle und/oder zu einer Auflösung einer eventuell vorgesehenen Vergütung der Welle während der Wärmebehandlung des Turbinenrads kommen. Auch wird die Verbindung zwischen der Welle und dem Turbinenrad über die Nabe des Turbinenrads nicht durch die Wärmebehandlung beeinträchtigt, weil sie erst nach der Wärmebehandlung hergestellt wird.

Eine Weiterbildung der Erfindung sieht vor, dass die Schutzschicht von der Nabe vor dem Verbinden wenigstens bereichsweise, insbesondere nur von einem Radrücken des Turbinenrads, entfernt wird. Vor dem Verbinden der Welle mit der Nabe des Turbinenrads muss der Bereich, in welchem das Verbinden beziehungsweise Fügen erfolgen soll, von der Schutzschicht befreit werden, um eine zuverlässige und dauerhafte Verbindung der Welle mit der Nabe zu ermöglichen. Die Schutzschicht behindert das Herstellen der Verbindung. Entsprechend wird die Schutzschicht von der Nabe entfernt, beispielsweise durch mechanische Bearbeitung wenigstens eines Bereichs der Nabe. Vorteilhafterweise ist es vorgesehen, dass die Befestigung der Welle an der Nabe nur im Bereich des Radrückens des Turbinenrads vorgesehen ist. Beispielsweise weist die Nabe dort eine Aufnahme für die Welle und/oder ein Befestigungsmittel der Welle auf, welches nur den Radrücken, nicht jedoch die gegenüberliegende Seite der Nabe, durchgreift. Mit Vorteil erfolgt daher das Entfernen der Schutzschicht ausschließlich von dem Radrücken des Turbinenrads. An dem Rädrücken des Turbinenrads ist üblicherweise die Temperaturbelastung vergleichsweise gering. Insbesondere liegen dort während des Betriebs des Abgasturboladers Temperaturen vor, welche kleiner sind als eine Oxidationstemperatur des Materials des Turbinenrads oder nur zu einer zu vernachlässigenden Oxidation führen. Entsprechend kann an dieser Stelle die Schutzschicht entfernt werden, ohne dass während des Betriebs des Abgasturboladers eine ungewünschte Oxidation beziehungsweise ungewünscht starke Oxidation zu befürchten ist.

Eine Weiterbildung der Erfindung sieht vor, dass nach dem Verbinden die Schutzschicht von einer dem Radrücken gegenüberliegenden Nabenstirnseite der Nabe des Turbinenrads entfernt wird. Die Nabenstirnseite begrenzt die Nabe des Turbinenrads auf der dem Radrücken gegenüberliegenden Seite. Sie liegt - bezogen auf eine Drehachse des Turbinenrotors - in radialer Richtung zwischen den einander gegenüberliegenden Turbinenschaufeln beziehungsweise um die Drehachse herum. Während die Turbinenschaufeln während des Betriebs des Abgasturboladers durch Beaufschlagung mit heißem Abgas einer hohen Temperaturbelastung unterworfen sind, trifft dies für den Radrücken üblicherweise nicht oder nur in vermindertem Ausmaß zu. Das Entfernen der Schutzschicht von der Nabenstirnseite wird nach dem Verbinden durchgeführt, also üblicherweise im Rahmen einer Endbearbeitung des Turbinenrotors.

Das Endbearbeiten kann auch ein Wuchten des Turbinenrotors einschließen. Das Entfernen wenigstens eines Teils des Materials an der Nabenstirnseite der Nabe und damit der Schutzschicht dient also beispielsweise dem Wuchten des Turbinenrotors. Im Bereich der Nabenstirnseite liegt die Nabe häufig in Form eines Vielkants beziehungsweise Mehrkants vor, welcher insbesondere dem Halten einer Drehwinkelposition des Turbinenrotors während der Montage des Abgasturboladers mit Hilfe eines auf den Vielkant abgestimmten Werkzeugs dient. Wie vorstehend bereits ausgeführt, ist die Temperatur an der Nabenstirnseite während des Betriebs des Abgasturboladers üblicherweise geringer als die Oxidationstemperatur. Entsprechend ist das Entfernen der Schutzschicht unproblematisch. Des Weiteren führt eine Oxidation an der Nabenstirnseite nicht zu einem Funktionsverlust des Turbinenrotors. Vielmehr wird der Betrieb des Abgasturboladers nicht beeinträchtigt.

Eine Weiterbildung der Erfindung sieht vor, dass nach dem Verbinden die Schutzschicht von einer von der Nabe abgewandten Schaufelstirnseite wenigstens einer der Turbinenschaufeln des Turbinenrads entfernt wird. Auch dies erfolgt beispielsweise im Rahmen der Endbearbeitung beziehungsweise des Wuchtens des Turbinenrotors. Die Schaufelstirnseite liegt an einem freien Ende der Turbinenschaufel vor, welches der Nabe abgewandt ist. Das Entfernen der Schutzschicht in diesem Bereich erfolgt üblicherweise ebenfalls durch mechanisches Bearbeiten, also beispielsweise durch Schleifen. Dabei wird ein Teil des Materials des Turbinenrads an dessen Schaufelstirnseite abgetragen.

Eine Weiterbildung der Erfindung sieht vor, dass die Schutzschicht an der Schaufelstirnseite durch erneutes Wärmebehandeln wieder ausgebildet wird. Die Schutzschicht wird wie bereits vorstehend ausgeführt durch Aufbringen oder Einbringen des Halogens und anschließendes Wärmebehandeln des Turbinenrads hergestellt beziehungsweise ausgebildet. Nachfolgend wird beispielsweise im Rahmen der Endbearbeitung, also nach dem Verbinden der Welle mit der Nabe des Turbinenrads, die Schutzschicht von der Schaufelstirnseite wenigstens bereichsweise entfernt. Weil die Turbinenschaufeln während des Betriebs des Abgasturboladers üblicherweise Temperaturen ausgesetzt sind, welche oberhalb der Oxidationstemperatur des Materials des Turbinenrads liegen, kann nach dem Entfernen der Schutzschicht eine Oxidation des Materials des Turbinenrads auftreten. Aus diesem Grund ist es vorgesehen, zumindest die Schaufelstirnseite einer erneuten Wärmebehandlung zu unterziehen, durch welche die Schutzschicht erneut ausgebildet wird.

Diese Wärmebehandlung kann auch in situ, also in dem Abgasturbolader während seines Betriebs, vorgesehen sein. Bei diesem treten hohe Temperaturen auf, welche zusammen mit dem noch in beziehungsweise auf der Oberfläche des Turbinenrads vorliegenden Halogen zu der erneuten Ausbildung der Schutzschicht führen. Entsprechend tritt nur zu Beginn des Betriebs des Abgasturboladers eine Oxidation des Turbinenrads auf. Nach der erneuten Ausbildung der Schutzschicht ist diese dagegen unterbunden. Bevorzugt wird bei dem Entfernen der Schutzschicht an der Schaufelstirnseite darauf geachtet, dass die Bearbeitungstiefe die Eindringtiefe des Halogens in die Oberfläche des Turbinenrads nicht überschreitet. Zudem wird die (erste) Wärmebehandlung, beispielsweise durch entsprechende Wahl der Temperatur und/oder der Dauer, derart durchgeführt, dass nicht die gesamte Menge des eingebrachten beziehungsweise aufgebrachten Halogens zur Oxidation verbraucht wird. Auf diese Weise verbleibt eine ausreichende Menge des Halogens auf beziehungsweise in der Oberfläche des Turbinenrads. Es kann auch vorgesehen sein, die Bereiche, von welchen die Schutzschicht entfernt wurde, erneut dem Aufbringen beziehungsweise Einbringen des Halogens zu unterziehen. Besonders bevorzugt werden dabei ausschließlich diese Bereiche mit dem Halogen beaufschlagt.

Eine Weiterbildung der Erfindung sieht vor, dass das Turbinenrad aus einem Titanaluminid, hergestellt wird. In der bekanntten Ausführungsform besteht das Turbinenrad aus einer Nickel-Basislegierung, welche eine Dichte von etwa 8 g/cm³ aufweist. Wie eingangs erläutert, ist es sinnvoll, die Masse des Turbinenrotors, insbesondere des Turbinenrads, soweit als möglich zu reduzieren, um die Massenträgheit zu verringern. Zu diesem Zweck eignet sich insbesondere die Titan-Aluminiumlegierung, weil diese eine deutlich geringere Dichte aufweist. Besonders bevorzugt ist liegt die Titan-Aluminium-Legierung als Titanaluminid (TiAl) vor. Die Titan-Aluminium-Legierung weist eine Dichte von etwa 4 g/cm³ auf. Durch die Aufbringung des Halogens auf die Oberfläche des Turbinenrads aus der Titan-Aluminiumlegierung kommt es bei dem anschließenden Wärmebehandelt zu einer Ausbildung einer thermisch beständigen Al₂O₃-Schicht. Diese schützt die Titan-Aluminiumlegierung, insbesondere also das Titanaluminid, vor einer unzulässigen Oxidation während des Betriebs des Abgasturboladers.

Eine Weiterbildung der Erfindung sieht vor, dass die Welle aus Stahl hergestellt wird. Die Welle besteht insbesondere aus einem von dem Material des Turbinenrads verschiednen Material. Beispielsweise wird zum Erlangen einer guten Dauerlauffestigkeit des Turbinenrotors Stahl verwendet. Dieser ist vorzugsweise gehärtet beziehungsweise vergütet. Um die Welle vor einer ungewollten Temperaturbeaufschlagung und entsprechend einer Auflösung der Vergütung zu schützen, wird die Welle erst nach dem Ausbilden der Schutzschicht mit der Nabe des Turbinenrads verbunden. Eine Ausnahme stellt. dabei das erneute Wärmebehandeln dar, welches beispielsweise während des Betriebs des Abgasturboladers erfolgt. Bei diesem treten im Bereich der Welle üblicherweise lediglich Temperaturen auf, welche die Vergütung der Welle nicht beeinträchtigen.

Eine Weiterbildung der Erfindung sieht vor, dass das Wärmebehandeln bei einer Temperatur von mindestens 500°C bis mindestens 900°C erfolgt. Bevorzugt erfolgt das Wärmebehandeln mit einer Temperatur, welche der während des Betriebs des Abgasturboladers erwarteten maximalen Temperatur entspricht. Auf diese Weise wird eine weitere, wenn auch geringfügige Oxidation unmittelbar nach der Inbetriebnahme des Abgasturboladers vermieden.

Eine Weiterbildung der Erfindung sieht vor, dass nach dem Verbinden wenigstens eine Lagerstelle der Welle gehärtet wird. Das Härten der Welle beziehungsweise der Lagerstelle erfolgt üblicherweise nach dem Verbinden, jedoch vor der Endbearbeitung beziehungsweise dem Wuchten des Turbinenrotors.

Die Erfindung wird nachfolgend anhand der in der Zeichnung dargestellten Ausführungsbeispiele näher erläutert, ohne dass eine Beschränkung der Erfindung erfolgt. Dabei zeigt:
- Figur 1: eine schematische Darstellung eines Turbinenrotors eines Abgasturboladers, welcher ein Turbinenrad mit einer Nabe und mit von der Nabe ausgehenden Turbinenschaufeln sowie eine Welle aufweist, und
- Figur 2: einen Längsschnitt durch den Turbinenrotor.

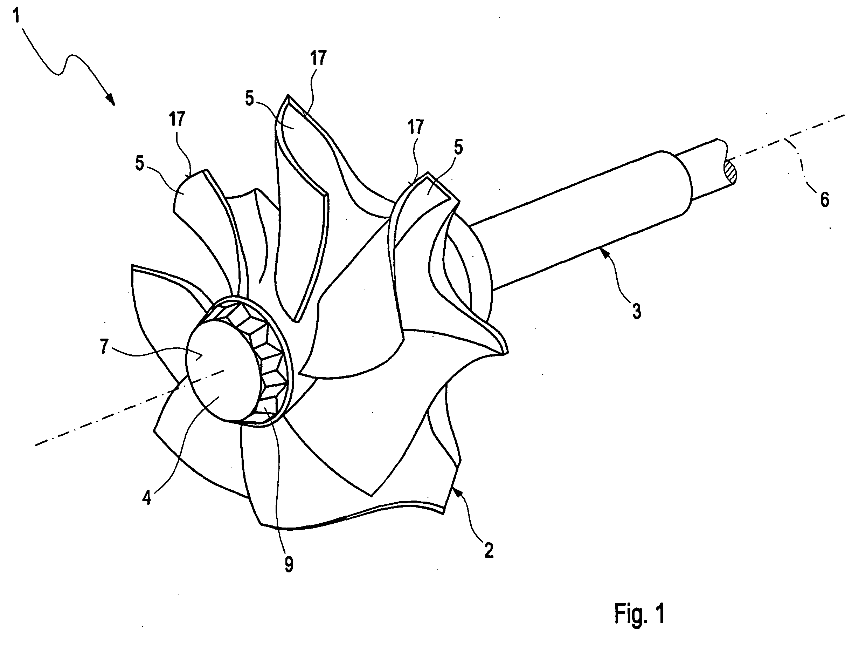

Die Figur 1 zeigt einen Turbinenrotor 1 eines nicht näher dargestellten Abgasturboladers. Der Turbinenrotor 1 besteht aus einem Turbinenrad 2 und einer Welle 3. Der Turbinenrotor 1 ist Bestandteil des Abgasturboladers, welcher einer Brennkraftmaschine zugeordnet ist. Der Turbinenrotor 1 ist üblicherweise drehbar in einem Turbinengehäuse gelagert, wobei über die Welle 3 ein Verdichterrad eines Verdichters mit dem Turbinenrad 2 wirkverbunden ist. Das Turbinenrad 2 setzt sich aus einer Nabe 4 und mehreren Turbinenschaufeln 5 zusammen, von welchen lediglich einige beispielhaft mit Bezugszeichen gekennzeichnet sind. Die Turbinenschaufeln 5 erstrecken sich - bezogen auf eine Drehachse 6 des Turbinenrotors 1 ausgehend von der Nabe 4 in radialer Richtung nach außen. Das Turbinenrad 2 besteht beispielsweise aus einer Aluminiumlegierung, beispielsweise einer Titan-Aluminium-Legierung, insbesondere einem Titanaluminid. Die Welle 3 besteht dagegen aus Stahl, beispielsweise niedrig legiertem Stahl, insbesondere 34CrMo4. Die Welle 3 ist mit der Nabe 4 des Turbinenrads 2 fest verbunden. Die Nabe ist im Bereich einer Nabenstirnseite 7, welche einem hier nicht erkennbaren Radrücken 8 des Turbinenrads 2 in axialer Richtung gegenüberliegt, als Vielkant beziehungsweise Mehrkant 9 ausgebildet. Dieser Vielkant 9 dient insbesondere dem Halten des Turbinenrads 2 beziehungsweise des Turbinenrotors 1 während einer Montage des Abgasturboladers.

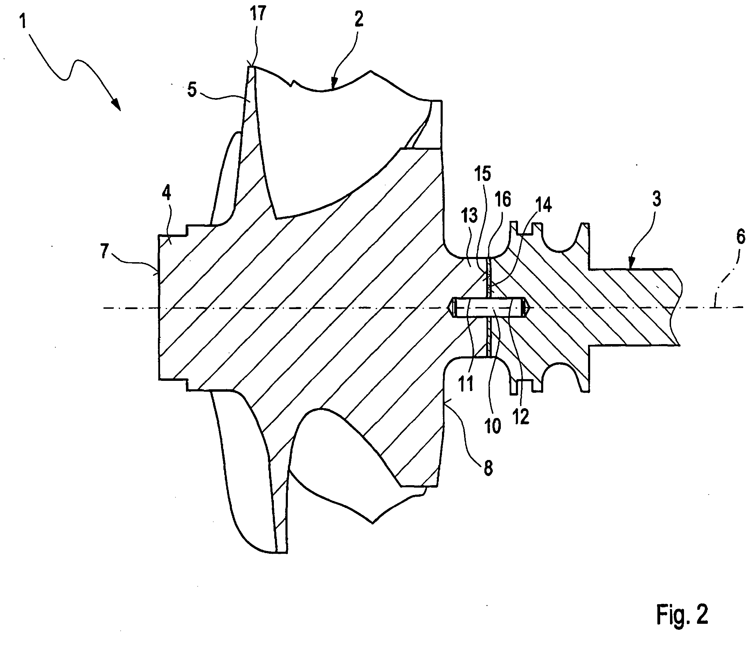

Die Figur 2 zeigt einen Längsschnitt des Turbinenrotors 1. Erkennbar sind wiederum das Turbinenrad 2 und die Welle 3. Es wird deutlich, dass das Turbinenrad 2 und die Welle 3 mithilfe eines als Zentrierstift 10 vorliegenden Befestigungsmittels miteinander verbunden sind, wobei der Zentrierstift 10 in eine Ausnehmung 11 des Turbinenrads 2 und eine Ausnehmung 12 der Welle 3 in axialer Richtung eingreift. Die Ausnehmung 11 liegt wenigstens bereichsweise in einem Befestigungsvorsprung 13 des Turbinenrads 2 vor, welcher sich in axialer Richtung (bezüglich der Drehachse 6) ausgehend von dem Radrücken 8 in Richtung der Welle 3 erstreckt. Der Befestigungsvorsprung weist eine Stirnseite 14 auf, welche im Wesentlichen parallel zu einer auf der dem Turbinenrad 2 zugewandten Seite der Welle 3 vorliegenden Stirnseite 15 liegt. Im Bereich der Stirnseiten 14 und 15 weisen der Befestigungsvorsprung 13 des Turbinenrads 2 und die Welle 3 im Wesentlichen identische oder zumindest ähnliche Durchmesser auf. Zwischen den Stirnseiten 14 und 15 kann eine Lötfolie 16 vorgesehen sein, mittels welcher eine dauerhafte Verbindung zwischen dem Turbinenrad 2 und der Welle hergestellt ist.

Bei einem Herstellen des Turbinenrotors 1 werden üblicherweise das Turbinenrad 2 und die Welle 3 separat voneinander hergestellt. Insbesondere wird das Turbinenrad 2 durch Gießen gefertigt. Üblicherweise werden bei dem Herstellen des Turbinenrotors 1 nach dem Gießen des Turbinenrads 2 eine Fügestelle des Turbinenrads 2, an welcher nachfolgend die Verbindung zu der Welle 3 hergestellt wird, sowie der Radrücken 8 mechanisch bearbeitet. Anschließend wird das Turbinenrad 2 mit der Welle 3, welche zuvor vergütet wurde, zu dem Turbinenrotor 1 zusammengefügt, wobei die Welle 3 mit dem Turbinenrad 2 verbunden wird. Nachfolgend kann wenigstens eine hier nicht dargestellte Lagerstelle der Welle 3 gehärtet werden. Dies ist jedoch optional. Anschließend wird der Turbinenrotor 1 endbearbeitet und gewuchtet. Für das Endbearbeiten und Wuchten wird mechanisch Material von dem Turbinenrotor 1 abgetragen, beispielsweise durch Schleifen oder dergleichen. Insbesondere erfolgt dabei ein Überschleifen des Vielkants 9 sowie einer Schaüfelstirnseite 17 wenigstens einer der Turbinenschaufeln 5. Die Schaufelstirnseite 17 ist an einem freien Ende der Turbinenschaufel 5 ausgebildet, welches auf der der Nabe 4 abgewandten Seite der Turbinenschaufel 5 vorliegt.

Weil der Turbinenrotor 1 während des Betriebs des Abgasturboladers mit einer hohen Temperatur beaufschlagt ist, also einer hohen Temperaturbelastung unterworfen ist, soll das Turbinenrad 2 mit einer hier nicht näher dargestellten Schutzschicht versehen werden. Dies ist insbesondere dann vorgesehen, wenn das Turbinenrad 2 aus der Titan-Aluminiumlegierung, beispielsweise dem Titanaluminid, besteht. In diesem Fall ist es von besonderer Bedeutung, dass das Turbinenrad 2 vor unerwünschter Oxidation geschützt wird, welche durch die hohe Temperaturbelastung verursacht wird. Zur Herstellung der Beschichtung soll zunächst ein Halogen auf beziehungsweise in wenigstens einen Teil der Oberfläche des Turbinenrads 2, insbesondere die gesamte Oberfläche, aufgebracht beziehungsweise eingebracht werden. Anschließend wird das Turbinenrad 2 wärmebehandelt, um die Schutzschicht auszubilden.

Wird diese Wärmebehandlung durchgeführt, nachdem die Welle 3 mit dem Turbinenrad 2 verbunden wurde, so wird die Welle 3 einer ungewünschten Temperaturbelastung ausgesetzt, durch welche es beispielsweise zu einer Auflösung einer eventuell vorgesehenen Vergütung der Welle 3 und/oder zu einer unerwünschten Oxidation kommt. Aus diesem Grund soll bei dem Herstellen des Turbinenrotors 1 wie folgt vorgegangen werden: Zunächst werden das Turbinenrad 2 und die Welle 3 bereitgestellt, wobei diese separat voneinander ausgebildet beziehungsweise hergestellt werden. Anschließend wird das Halogen auf beziehungsweise in die Oberfläche des Turbinenrads 2 eingebracht und nur das Turbinenrad 2 anschließend wärmebehandelt. Erst nach dem Wärmebehandeln wird die Welle 3 mit dem Turbinenrad 2 beziehungsweise dessen Nabe 4 verbunden. Zum Herstellen der Verbindung wird vor dem Verbinden die Schutzschicht wenigstens bereichsweise von der Nabe 4, insbesondere von dem Radrücken 8, entfernt. Insbesondere ist es vorgesehen, die Schutzschicht nur von dem Befestigungsvorsprung 13, welcher Bestandteil der Nabe 4 ist, und insbesondere nur von dessen Stirnseite 14 zu entfernen, um eine sichere Verbindung zu der Welle 3 zu ermöglichen. Das Verbinden der Welle 3 mit der Nabe 4 ist insbesondere mithilfe der Lötfolie 16 vorgesehen, wobei selbstverständlich auch andere Befestigüngsarten Anwendung finden können.

Nach dem Verbinden der Welle 3 mit dem Turbinenrad 2 erfolgt - soweit gewünschtdas wenigstens bereichsweise Härten der Welle 3 beziehungsweise wenigstens einer Lagerstelle der Welle 3. Anschließend wird die Endbearbeitung beziehungsweise das Wuchten des Turbinenrotors 1 durchgeführt. Zu diesem Zweck wird Material von dem fertigen Turbinenrotör 1 abgetragen, insbesondere im Bereich der Nabenstirnseite 7 beziehungsweise des Vielkants 9. Auch von der Schaufelstirnseite 17 wird üblicherweise Material abgetragen. Entsprechend wird in diesen Bereichen die Schutzschicht wieder entfernt. Daher ist es vorgesehen, die Schutzschicht an der Schaufelstirnseite 17 durch erneutes Wärmebehandeln wieder auszubilden. Dieses erneute Wärmebehandeln kann insbesondere durch einen Betrieb des Abgasturboladers erfolgen. Bei diesem wird durch noch in dem Turbinenrad 2 enthaltenes Halogen die Schutzschicht, insbesondere in Form der Al₂O₃-Schutzschicht, hergestellt. Entsprechend ist es besonders bevorzugt vorgesehen, dass das Entfernen der Schutzschicht von der Schaufelstirnseite 17 derart erfolgt, dass die Bearbeitungstiefe geringer ist als die Eindringtiefe des Halogens in das Material des Turbinenrads 2.

Das Halogen kann prinzipiell beliebig gewählt sein. Besonders bevorzugt wird jedoch Fluor, Chlor, Brom, Jod oder eine Mischung aus diesen Elementen verwendet. Das Aufbringen beziehungsweise Einbringen des Halogens kann durch ein lonenimplantationsverfahren, ein Tauchverfahren, ein Sprühverfahren, ein Aufstreichverfahren oder dergleichen erfolgen.

## Patentansprüche

1. Verfahren zum Herstellen eines auch bei hohen Temperaturen oxidationsbeständigen Turbinenrotors (1) eines Abgasturboladers, wobei der Turbinenrotor (1) aus einem Turbinenrad (2) mit einer Nabe (4) und mit von der Nabe (4) ausgehenden Turbinenschaufeln (5) sowie einer Welle (3) besteht, wobei das Turbinenrad (2) aus einer Titan-Aluminiumlegierung hergestellt wird, mit dem Schritt:
- Bereitstellen des Turbinenrads (2) sowie der Welle (3); **gekennzeichnet durch** die Schritte:
- Ausbilden einer Schutzschicht **durch** Aufbringen oder Einbringen eines Halogens auf beziehungsweise in die Oberfläche des Turbinenrads (2) sowie anschließendes Wärmebehandeln des Turbinenrads (2); und
- Verbinden der Welle (3) mit der Nabe (4) des Turbinenrads (2) nach dem Ausbilden der Schutzschicht.

2. Verfahren nach Anspruch 1, **dadurch gekennzeichnet, dass** die Schutzschicht von der Nabe (4) vor dem Verbinden wenigstens bereichsweise, insbesondere nur von einem Rädrücken (8) des Turbinenrads (2), entfernt wird.

3. Verfahren nach einem der vorhergehenden Ansprüche, **dadurch gekennzeichnet, dass** nach dem Verbinden die Schutzschicht von einer dem Radrücken (8) gegenüberliegenden Nabenstirnseite (7) der Nabe (4) des Turbinenrads (2) entfernt wird.

4. Verfahren nach einem der vorhergehenden Ansprüche, **dadurch gekennzeichnet, dass** nach dem Verbinden die Schutzschicht von einer von der Nabe (4) abgewandten Schaufelstirnseite (17) wenigstens einer der Turbinenschaufeln (5) des Turbinenrads (2) entfernt wird.

5. Verfahren nach einem der vorhergehenden Ansprüche, **dadurch gekennzeichnet, dass** die Schutzschicht an der Schaufelstirnseite (17) durch erneutes Wärmebehandeln wieder ausgebildet wird.

6. Verfahren nach einem der vorhergehenden Ansprüche, **dadurch gekennzeichnet, dass** das Turbinenrad (2) aus einem Titanaluminid hergestellt wird.

7. Verfahren nach einem der vorhergehenden Ansprüche, **dadurch gekennzeichnet, dass** die Welle (3) aus Stahl hergestellt wird.

8. Verfahren nach einem der vorhergehenden Ansprüche, **dadurch gekennzeichnet, dass** das Wärmebehandeln bei einer Temperatur von mindestens 500°C bis mindestens 900°C erfolgt.

9. Verfahren nach einem der vorhergehenden Ansprüche, **dadurch gekennzeichnet, dass** nach dem Verbinden wenigstens eine Lagerstelle der Welle (3) gehärtet wird.

## Claims

1. Method for producing a turbine rotor (1) of an exhaust gas turbocharger, which is resistant to oxidation even at high temperatures, wherein the turbine rotor (1) comprises a turbine wheel (2) having a hub (4) and turbine blades (5) extending from the hub (4) and a shaft (3), the turbine wheel (2) being made from a titanium aluminium alloy, comprising the steps:
- providing the turbine wheel (2) and the shaft (3); **characterised by** the steps:
- forming a protective coating by applying or incorporating a halogen on or in the surface of the turbine wheel (2) and thereafter heat treating the turbine wheel (2); and
- connecting the shaft (3) to the hub (4) of the turbine wheel (2) after the protective coating is formed.

2. Method according to claim 1, **characterised in that** prior to connecting the protective coating is removed at least partly from the hub (4), in particular only from a wheel rear (8) of the turbine wheel (2).

3. Method according to any one of the preceding claims, **characterised in that** after connecting the protective coating is removed from a hub front face (7) of the hub (4) of the turbine wheel (2) that faces the wheel rear (8).

4. Method according to any one of the preceding claims, **characterised in that** after connecting the protective coating is removed from a blade front face (17) of at least one of the turbine blades (5) of the turbine wheel (2) that faces away from the hub (4).

5. Method according to any one of the preceding claims, **characterised in that** the protective coating is formed again on the blade front face (17) by repeating the heat treatment.

6. Method according to any one of the preceding claims, **characterised in that** the turbine wheel (2) is made of a titanium aluminide.

7. Method according to any one of the preceding claims, **characterised in that** the shaft (3) is made of steel.

8. Method according to any one of the preceding claims, **characterised in that** the heat treatment is performed at a temperature of at least 500°C. to at least 900° C.

9. Method according to any one of the preceding claims, **characterised in that** after connecting at least one bearing of the shaft (3) is hardened.

## Revendications

1. Procédé de fabrication d'un rotor de turbine (1) d'un turbocompresseur résistant à l'oxydation même aux températures élevées, dans lequel la rotor de turbine (1) est constitué d'une roue de turbine (2) avec un moyeu (4) et des pales de turbine (5) saillant du moyeu (4) ainsi que d'un arbre (3), dans lequel la roue de turbine (2) est fabriquée en alliage de titane et d'aluminium, avec l'étape consistant à :
- mettre en oeuvre la roue de turbine (2) ainsi que
l'arbre (3) ;
**caractérisé par** les étapes consistant à :
- former une couche de protection par application ou introduction d'un halogène sur, éventuellement dans la surface de la roue de turbine (2) ainsi que par traitement thermique connexe de la roue de turbine (2) ; et
- relier l'arbre (3) au moyeu (4) de la roue de turbine (2) après formation de la couche de protection.

2. Procédé selon la revendication 1, **caractérisé en ce que** la couche de protection est éliminée du moyeu (4) avant la liaison au moins par zones, en particulier d'un dos (8) de la roue de turbine (2).

3. Procédé selon l'une quelconque des revendications précédentes, **caractérisé en ce que**, après la liaison, la couche de protection est supprimée d'une face avant (7) du moyeu (4) de la roue de turbine (2) opposée au dos (8) de la roue.

4. Procédé selon l'une quelconque des revendications précédentes, **caractérisé en ce que**, après la liaison, la couche de protection est supprimée d'une face avant (17) au moins de l'une des pales (5) de la roue de turbine (2) opposées au moyeu (4).

5. Procédé selon l'une quelconque des revendications précédentes, **caractérisé en ce que** la couche de protection est reformée sur la face avant (17) des pales par un nouveau traitement thermique.

6. Procédé selon l'une quelconque des revendications précédentes, **caractérisé en ce que** la roue de turbine (2) est formée d'un aluminure de titane.

7. Procédé selon l'une quelconque des revendications précédentes, **caractérisé en ce que** l'arbre (3) est constitué d'acier.

8. Procédé selon l'une quelconque des revendications précédentes, **caractérisé en ce que** le traitement thermique se fait à une température d'au moins 500°C à au moins 900°C.

9. Procédé selon l'une quelconque des revendications précédentes, **caractérisé en ce que**, après la liaison, au moins un point d'appui de l'arbre (3) est trempé.
